# EUROPEAN PATENT SPECIFICATION

(11) **EP 4 203 331 B1**
(45) Date of publication and mention of the grant of the patent: **26.11.2025**
(21) Application number: 21216842.1
(22) Date of filing: 22.12.2021
(51) Int. Cl.: H04B 3/46, G01R 27/04, G01R 31/00, H04B 3/54, H04M 3/30

(54) **METHOD AND DEVICE FOR DETERMINING DISTANCES BETWEEN NODES IN A NETWORK**
VERFAHREN UND VORRICHTUNG ZUR BESTIMMUNG VON ABSTÄNDEN ZWISCHEN KNOTEN IN EINEM NETZWERK
PROCÉDÉ ET DISPOSITIF DE DÉTERMINATION DE DISTANCES ENTRE DES NOEUDS DANS UN RÉSEAU

(43) Date of publication of application: 28.06.2023
(73) Proprietor: Yamar Electronics Ltd., 6249220 Tel-Aviv (IL)
(72) Inventor: MARYANKA, Yair, 6249220 Tel-Aviv (IL); PRIEL, Eran, 6249220 Tel-Aviv (IL)
(74) Representative: Heilein, Ernst-Peter

(56) References cited:
- EP-A1- 3 667 902

## Description

### FIELD OF THE INVENTION

The present invention relates to method of determining a physical distance between a primary node and a secondary node in a network with a plurality of nodes.

### BACKGROUND OF THE INVENTION

Physical networks comprise usually a plurality of nodes or entities that are interconnected by means of cables or wires (lines). The cables serve as carrier for electrical or optical signals during communication of the involved nodes.

In practice there is a need to ensure proper communication between the interconnected entities. The characteristics of the connecting cables can be used to achieve this goal. One method to determine said line characteristics is the time-domain reflectometry (TDR) on the basis of reflected waveforms on the interconnecting lines. This method is usually used to characterize and/or trace faults in line or cables, like for instance co-axial or twisted pair or the like.

During a TDR measurement sequence one of the involved nodes serving as a master for instance starts by first transmitting an incident signal onto the cable which is subsequently followed by a second, receiving phase, where the TDR enabled master node listens for its reflections. In case that the cable (or interconnecting line) has uniform impedance throughout and is properly terminated, then no reflections are formed as the remaining incident signal will be fully absorbed at the far-end by the termination corresponding to a normal condition.

However, if there are impedance variations along the cable for instance due to malfunctions or physical line defects, then some of the incident signal will be reflected back to the signal source. The time leg between the transmitted signal and the receiving of the reflected signal allows calculation of the physical distance between the signal source and the element causing the reflection.

Another possibility of determination of line characteristics is based on an ongoing repetition of a pulse that endlessly travels along the distance to be detected. For calculation purposes a pulse repeater at both ends of the distance or cable to be measured is to be embodied.

Alternatively, the so-called "Klein Tools" distance measuring devices may be implemented that estimate the length of a particular cable by assessing the total capacitance of the cable attached to the unit and then comparing that to a present or user-defined capacitance per unit-length.

Finally, EP3667902A1 relating to a apparatus and a method for determining an order of power devices in power generation systems should be noted.

### PROBLEM TO BE SOLVED

Thus, one problem to be solved according to the present invention is providing a robust method to determine the distance between entities in a network.

### SUMMARY OF THE INVENTION

This problem is solved by the appended independent claims. Preferred embodiments of the invention are defined by the dependent claims.

The present invention pertains to a method for determining the physical distance between nodes, entities or devices interconnected in a network. The term physical distance between nodes means that the relative distance between two concerned nodes is determined. The present invention further relates to a system enabled to perform methods in accordance with the present invention. Thus, the system is enabled to execute the methodology of the present invention.

According to the present invention a method for determining a physical distance, that is the relative physical distance, between nodes in a wire-based network is disclosed. The method comprises providing a primary node within the network. Next identification of at least two connected secondary nodes within the network by means of the primary node is performed, wherein each secondary node comprises a remotely controllable capacitor (connected in parallel to the powerline YM). Subsequently the primary node requests the at least two identified secondary nodes to activate their corresponding controllable capacitor wherein the identifying and requesting steps are performed by means of a communication channel between said nodes, which is independent of the wired network. Thet means that a second communication channel for specific operational step may be implemented. Thus, increasing the robustness of the system is ensured. A wire-based network (N), according to the Invention also generates and transmits a measurement signal within the network. However, the controllable capacitor of each secondary node is independently activable. The primary node performs next measuring, processing, and recording reflected signal characteristics within the network. Accordingly, this process is individually repeated for each and every secondary node within the network. Finally determining the physical distance between the primary node and the secondary nodes based on recorded reflected processed signal characteristics within the wire-based network is carried out. The physical distance corresponds to the relative physical distance between the primary node and all interconnected secondary nodes.

The method according to the present invention ensures robust measuring of the relative ordering of nodes connected through a cable, wire and/or electrical lines based on a measurement signal broadcasted in a network by a master or primary node respectively. According to the invention each primary and secondary node may be characterized by a unique logical identification, which is provided for the interconnected entities by means of a known "who-is" command sent by the primary node. In turn each interconnected secondary node receiving the "who-is" command sends back its unique identification number (ID). The ID corresponds to an internal arbitrary serial identification number.

According to the invention the physical distance between nodes corresponds to the relative distance between primary node and the interconnected respective secondary node. One skilled person will understand that physical and/or relative distance is similarly used, and the indeed real distance of the cable may be calculated based on known cable characteristics (like for instance inductance per meter or the like).

By the invention an ordering of distances between primary node and interconnected nodes is achieved on the basis of the determined relative distances.

According to one embodiment, each device serving as a primary node may be equipped with a communication module like for instance commonly known DCB1M module developed by Yamar Electronics adapted to convey signals (protocol signals) over lines, wires, power lines or the like.

According to the present invention, the connected secondary nodes comprise a switchable or controllable capacitor or other equivalent device adapted to be remotely controlled by the primary master. However, the controllable capacitor or device is adapted to reflect received signals over the connection cables, lines, wires, or the like. One skilled person will understand that a capacitor, whose capacitance is locally set or remotely controlled by a digital message carried over said cables, so as to judiciously tune the capacitance to a particular desired value, is allowing one to determine the cable characteristics. The capacitor value can be tuned to reflect impinging signals, or otherwise to exhibit perfect impedance matching to the cable so as to eliminate reflections. The primary node according to the present invention is adapted to record the received reflected signal characteristics caused by the capacitor of the secondary node in storage means like a register or the like. According to the invention the primary node is adapted to build a data base (within storage means) consisting of reflected signal characteristics enabling the primary node to determine the (relative) physical distance between primary node and the concerned secondary nodes. The distance corresponds in turn to the cable or line length respectively necessary for technical or maintenance purposes within the network for instance.

The methodology in accordance with the present invention provides a technique of identifying the physical ordering of all existing secondary nodes connected to a cable with respect to the primary node. Hence, each secondary node is equipped with an on-board, dedicated capacitor that can be loaded onto the cable using a remote command signal, i.e. this capacitor may be connected between the two conducting wires of the cable by means of a remotely controlled switch according to one embodiment.

The present invention hence relates to a system of primary nodes and secondary nodes interconnected in a network adapted to perform the above-mentioned methodology.

### EMBODIMENTS OF THE INVENTION

According to an embodiment of the present invention each secondary node comprises an identifier transmittable to the primary node during the identifying step, the identifier corresponding to an unique logical identification of each secondary node in the network. Hence, each interconnected secondary node in the network can be identified by the primary node or master node. Therefore, the methodology of the present invention can be performed for all concerned node pairs.

For bidirectional communication within the network the primary node and/or the secondary nodes may be equipped with transceiver modules or the like. Thus, the messaging over the wired network is enabled.

According to an embodiment processing the said data base (within storage means) consisting of reflected signal characteristics is carried out to obtain a unique frequency response for each secondary node. Said frequency response is stored and used to determine a specific signal shape, the specific shape being associated with a specific frequency value within the frequency range. Thus, the primary node is adapted to analyze the waveform of the reflected measurement signal to identify specific forms like for instance a signal drop depicted as a notch or similar. The method is adapted to identify and store such unique incidents in the waveform to determine the relative distance between the nodes accordingly.

As mentioned, the specific signal shape is a signal notch. The notch is characterized by a signal drop in the waveform depicted in a graph frequency versus signal amplitude measured in dB for instance. By means of this feature an exact frequency value where the aforementioned signal drop occurs may be determined. All concerned values are next to be stored in a data base or storage register for further processing.

According to an embodiment said remotely controllable capacitor comprises a capacitor whose capacitance value can be set remotely. Thus, a flexible controlling can be ensured, whereby the capacitance value can be set by means of user input or software control for instance. Therefore, the secondary nodes equipped with such a controllable capacitor can be easily implemented in existing networks for instance.

Furthermore, each secondary node comprises a remotely controllable reflective material or reflection means in general. By this means the above-mentioned capacitor can be replaced by said reflection means or the like, therefore improving the methodology in accordance with the present invention.

The principle of the present invention may be applied on all kinds of networks like for instance: wire-based networks, power line, optical, Ethernet or a proprietary cable-based networks etc. Hence, a flexible implementation of the aforementioned methodology is ensured.

According to a further aspect of the present invention a system comprising a primary node and at least two secondary nodes is provided. The system is adapted to perform the operational sequence in accordance with the invention.

The accompanying figures are included to provide a further understanding of the present invention and are incorporated in and constitute a part of this specification. The drawings illustrate the embodiments of the present invention and together with the description, serve to explain the principles of the invention. Other embodiments of the present invention and many of the intended advantages of the present invention will be readily appreciated as they become better understood by reference to the following detailed description.

The various aspects, embodiments, implementations or features of the invention can be used separately or in any combination.

### BRIEF DESCRIPTION OF THE DRAWINGS

The invention is explained in further detail, by way of example and with reference to the accompanying drawings wherein:
- Fig. 1: shows a one-dimensional network or system in accordance with the present invention;
- Fig. 2: depicts a two-dimensional network according to an embodiment;
- Fig. 3: schematically shows the commands of a data protocol according to an embodiment of the invention;
- Fig. 4: discloses a simplified connection between the primary node and one secondary node according to one embodiment; and
- Fig. 5: illustrates the waveform of the reflected signal by the secondary node according to the invention.

### DESCRIPTION OF THE INVENTION

In the following the principle of the present invention will be described with reference to the appended figures.

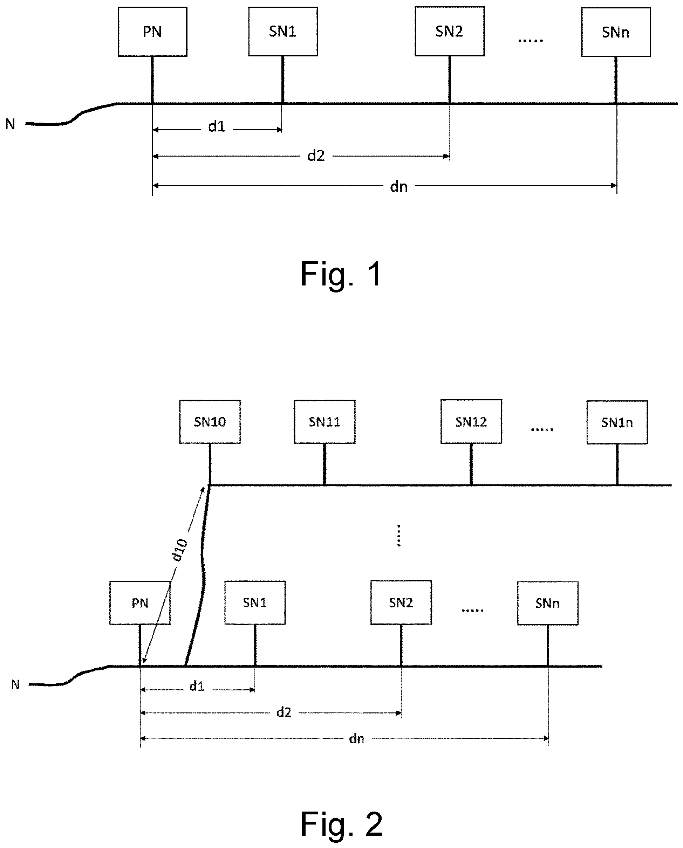

Fig. 1 schematically a shows one-dimensional network N of secondary nodes SN1..n and one primary node PN according to the present invention.

According to one embodiment the network N of communicating nodes PN and SN are interconnected by means of a wire-line (electric cable) or the like. The respective nodes are connected at arbitrary distances d1..n with respect to the primary node PN which is implemented in the existing network.

During the initialization phase or built-up phase, respectively of the network it is important for proper operation, as well as for ease of maintenance, to uniquely identify all the secondary nodes SN interconnected in the network along with their relative distances (ordering) d1...n with respect to the primary node PN of the network.

According to an exemplary embodiment a network of solar panels (acting as secondary nodes) SN communicating with a master controller (acting as the primary node) PN may be implemented according to the present invention.

The solar panel nodes SN are technically identical except for a unique internal serial number ID. The master controller acting as a primary node PN should first identify all the connected panels SN to be able to communicate and monitor their operation according to the present invention. This identification step may be performed by using a "who is" command.

Afterwards the master device or primary node PN respectively has the information about all interconnected secondary nodes SN, i.e. solar panels.

It should be noted that other commands or sequences are implementable enabling the primary node PN to get information about the number and ID's of the interconnected secondary nodes SN within the gist of the present invention.

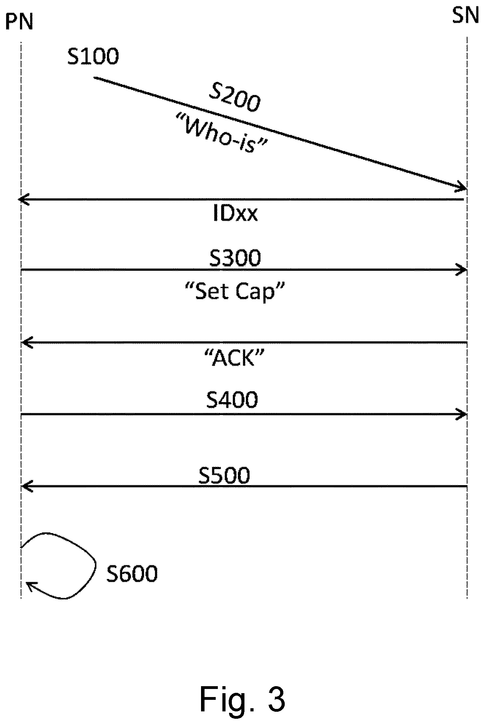

The serial number ID can be used as (logical) unique identification in the network, and is acquired by the master PN during initialization phase. The master controller or primary node, respectively PN should also be able to identify the (physical) whereabouts of each panel SN, or alternatively their physical ordering in the network N. Then, if a specific panel reports a problem (or if a panel is not responding for any reason), based on the association of logical identification and physical whereabouts, that panel can be easily tracked (physically) for maintenance/replacement. The primary node PN is adapted to perform the method according to the present invention as it will be described in more detail with reference to Fig. 3.

Under the term physical ordering is meant the distance d1 to dn between primary node PN and respective secondary nodes SN1..n as schematically shown with reference to Fig. 1.

Further, Fig. 2 shows a two-dimensional network of secondary nodes controllable by means of a master device implemented as a primary node PN, whereby the method according to the present invention is enabled to determine the (relative) physical distances between master node PN and the corresponding secondary nodes. The principle of initialization of the network was described with reference to Fig. 1 above.

Fig. 3 shows the message and commands communication between one primary node and a secondary node in accordance with the present invention by means of a sequence diagram. Accordingly, the method consists of two-phase described in more detail below.

During a first stage a logical identification of all connected secondary nodes SN within the network N controlled by the primary node PN is performed. The primary node PN is defined in a first step S100, whereby the primary node serves as a master device for all connected secondary nodes in the network N. The primary node may control all interconnected network N parties and especially the plurality of secondary nodes SN1 to SNn.

In a next S200 the primary node sends a "who-is" command over the network by employing a power line communication device such as DCB1M from Yamar Electronics for instance. It should be noted that other devices or techniques to broadcast a who-is message are conceivable within the scope of the present invention. Any other suitable method or sequence to identify the interconnected nodes with the corresponding internal ID's is within the scope of the present invention.

In turn all secondary nodes SN receiving the "who-is" command, stall their response by a time-delay proportional to their internal (arbitrary) serial identification number (ID) and only then reply to the primary node by transmitting their IDxx. Each secondary node within the network thus will be identified by the primary node PN. Within the generated time-delay, each secondary node SN senses the cable of the network N for possible responses generated by other secondary nodes. If no such response is present during this time interval, this specific secondary node will respond with data containing its ID number over the cable. Otherwise, this secondary node will wait for the next "who-is" command to be received from the Primary node. The primary node PN repeats the "who-is" command until there is no response for the maximum delay possible. Provision is also provided to handle, so-called collisions, when two, or more, secondary nodes SN transmit on the cable simultaneously.

After finishing the first stage of the sequential diagram all connected secondary nodes SN1 to SNn within the network N are identified by their own logical ID by the primary node PN. Next a physical identification of the secondary nodes SN will be performed, whereby the relative ordering of distances between the primary node PN and any of the interconnected secondary nodes identified during the first stage of the procedure will be executed.

Subsequently, following steps are executed for all identified, i.e. interconnected secondary nodes SN1 to SNn within the physical network. The primary node PN commands a specific secondary node SN to load the cable (between 2-ports) by it's on-board capacitor, using a "Set-Cap" command S300.The concerned secondary node SN has been identified by its ID during the first stage of the sequential diagram of the system. The capacitance value of said on-board capacitor can be locally tuned or remotely tuned using an adequate "Tune-Cap" command.

Next the primary node PN generates S400 a sweep of frequencies starting from minimum frequency, f_min, and ending at a maximum frequency, f_max in form of a measurement signal in accordance with the present invention.

Thereafter the primary node outputs the generated signal sweep from f_min to f_max to the cable in step S400 and records the amplitude (or impedance) measured on the cable for each frequency within the waveform of the measurement signal during step S500. After the recording the primary node may instruct the concerned secondary node SN to disconnect (un-load) its capacitor from the cable or line of the analyzed network N.

Next determining S600 of the physical distance d1 to dn between the primary node PN and the at least secondary node SN on the basis of recorded reflected, i.e. processed, signal characteristics within the wire based network N will be executed. The primary node PN is adapted to extract a "frequency-response" based on the recorded set of measurements, whereby said response characterizes the particular a link between the primary node PN and the specific secondary node SN1 (for instance).

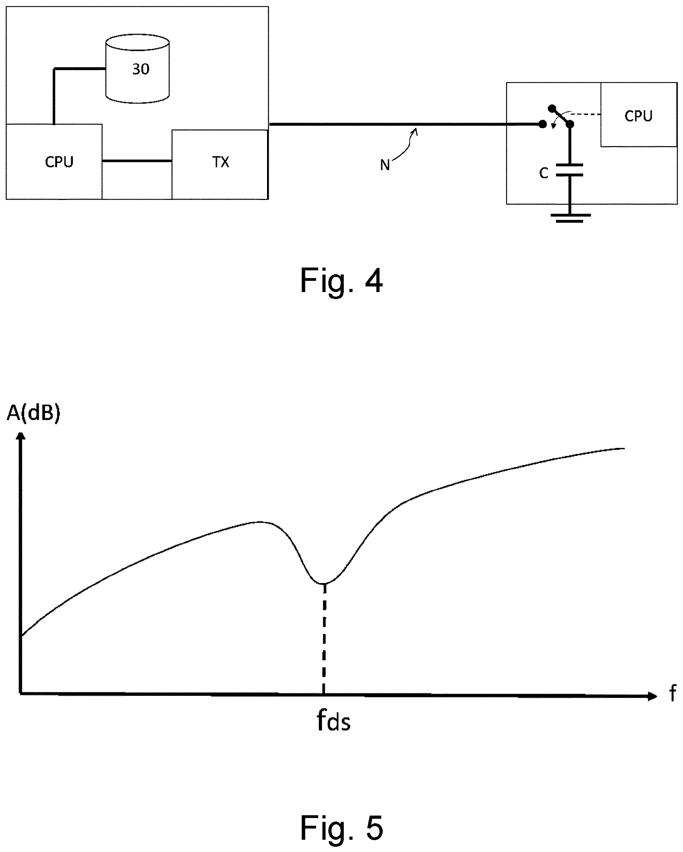

According to the invention, the primary node is adapted to screen the reflected signal waveform (schematically shown with reference to Fig. 5) for a "notch" (typically a local drop in amplitude magnitude) in the frequency-response and records its specific frequency value (per-node). That is the determining step is performed for each interconnected secondary node SN1 to SNn with respect to the master device or primary node PN, accordingly. The notch or signal drop DS is schematically shown in Fig. 5. The primary node PN or its CPU respectively is adapted to screen the reflected waveform and identify the specific frequency value fds where the signal drop DS occurs.

As previously mentioned, the primary node PN recorded and stored the reflected waveforms of the measurement signal, whereby the respective identified frequencies fds are the basis for determining the relative physical distances between the node pair PN, SN. Hence, the primary node PN will determine the relative physical ordering of the secondary nodes SN1 to SNn in the network N based on the frequencies for instance fds (cf. Fig. 5) of the associated or corresponding notches DS. The higher the notch frequency fds, the closer is the secondary node SNn to the primary node PN. That means that the fds measured for the second node SN2 (cf. Fig. 1) is lower than the frequency of the signal drop DS measured for the first secondary node SN1. According to the invention the sequential operation is iteratively performed in a step S600 for all connected secondary nodes in the network and the values will be stored in a data base or storing means within the primary node PN. The stored frequency values or waveforms of the reflected measurement signal are thus available for further processing or the like.

Fig. 4 shows according to an embodiment a primary node PN and a secondary node SN connected in a network N as an example. According to the invention the primary node comprises at least a CPU for controlling the operations, a transceiver TX to send and receive signals conveyed via the wired network N and storing means 30 in form of a data base or the like. The storage 30 is adapted to store waveforms, frequency responses or specific frequency values fds as mentioned above.

The secondary node may also have a transceiver or adequate means (not shown) functionally connected to the network N. Further according to the invention all secondary nodes are equipped with a controllable capacitor or other means for reflecting the measurement signal broadcasted on the network N by the primary node via its transceiver TX.

It should be noted that exemplary a wired network N was depicted and described but an optical network is implementable according to the invention. Thus, the discrete capacitor C may be replaced by other reflecting means like for instance some reflective material or reflection means in general.

It should be noted that the CPU of the primary node PN may be adapted to operate as a network analyzer to enable the frequency detection mentioned above.

It is also conceivable that machine learning procedures to analyze the received reflected signal or otherwise operate the system may be implemented.

Fig. 5 shows exemplarily a processed waveform (frequency response) based on received reflected signal caused by the respective capacitor within the secondary node. As mentioned, the primary node detects and records the frequency value fds of the signal drop or notch DS according to the corresponding secondary node SN. The storage means 30 within the master node PN stores each frequency value or each processed waveform for each interconnected secondary node in the network.

According to the invention the network may be a power-line network, coaxial cable network, an optical network, or the like.

Furthermore, it is conceivable that protocol messages between the primary node and the respective secondary nodes are conveyed by means of another communication channel as the main network N. This can be performed wireless RF, laser or even optically. Also conceivable is usage of power line modems or the like.

According to the invention a battery management system, LED network, solar panels or any other sensors and actuators network may define the network. Even a smart home ecosystem may be controlled and operated based on the methodology according to the present invention.

It is to be noticed that the term "comprising", used in the claims and description, should not be interpreted as being restricted to the means listed thereafter; it does not exclude other elements or steps. Thus, it is to be interpreted as specifying the presence of the stated features, steps or components as referred to, but does not preclude the presence or addition of one or more other features.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

While this invention has been described in terms of several preferred embodiments, there are alterations, permutations, and equivalents, which fall within the scope of this invention. For example, although the invention has been primarily directed at wired or cable connected networks, it should be noted that in some cases other networks may also be used in place of the described wire-based networks. Other types of networks like optical or even radio based may also be utilized.

The invention is preferably implemented by hardware, software or a combination of hardware and software. The software can also be embodied as computer readable code on a computer readable medium. The computer readable medium is any data storage device that can store data which can thereafter be read by a computer system. Examples of the computer readable medium include read-only memory, random-access memory, CD-ROMs, DVDs, magnetic tape, optical data storage devices, and carrier waves. The computer readable medium can also be distributed over network-coupled computer systems so that the computer readable code is stored and executed in a distributed fashion.

## Claims

1. Method for determining a physical distance between nodes (PN, SN) in a wire-based network (N), comprising:
- Providing (S100) a primary node (PN) within the network (N);
- Identifying (S200) at least two connected secondary nodes (SN) within the network by means of the primary node (PN), wherein each secondary node (SN) comprises a remotely controllable capacitor;
- Requesting (S300) the at least two identified secondary nodes (SN) to independently activate their corresponding controllable capacitor by the primary node (PN);
- wherein the identifying and requesting steps (S200, S300) are performed by means of a communication channel between said nodes, which is independent of the wired network;
- Generating and transmitting (S400) a measurement signal within the network by the primary node (PN) and subsequently measuring, processing and recording (S500) reflected signal characteristics; and
- Determining (S600) the physical distance (d) between the primary node (PN) and the at least two secondary nodes (SN) on the basis of recorded reflected processed signal characteristics within the wire-based network (N).

2. Method according to claim 1, wherein each secondary node comprises an identifier (ID) transmittable to the primary node (PN) during the identifying step, the identifier corresponding to an unique logical identification of each secondary node (SN) in the network (N).

3. Method according to at least claim 1 or 2, wherein the primary node (PN) comprises at least one transceiver (TX) for sending and receiving signals within the network (N).

4. Method according to at least one of the preceding claims, wherein the measurement signal corresponds to a linear signal sweep in a frequency range between two predetermined values (fmin, fmax).

5. Method according to claim 4, wherein recording (S500) comprises storing of a frequency response with respect to said frequency range of said sweep signal by the primary node (PN).

6. Method according to claim 5, further comprising processing the stored frequency response to determine a specific signal shape, the specific shape being associated with a specific frequency value within the frequency range.

7. Method according to claim 6, wherein the specific signal shape is a signal notch.

8. Method according to at least one of the preceding claims, wherein said remotely controllable capacitor comprises a capacitor whose capacitance value can be set remotely.

9. Method according to at least one of the preceding claims, wherein each secondary node (SN) comprises a remotely controllable reflective material or reflection means in general.

10. Method according to claims 6 and 7, further comprising storing the specific frequency value with respect to each secondary node of the wire-based network in storing means (30) associated with the primary node (PN).

11. Method according to claim 10, wherein determining of the physical distance (d) between the primary node and the at least two secondary nodes is performed on the basis of the frequency values within said storing means (30).

12. Method according to at least one of the preceding claims, wherein the wire-based network (N) is a power line, an optical, an Ethernet or a proprietary cable-based network.

13. System comprising a primary node (PN) and at least two secondary nodes (SN) interconnected in a wire-based network (N), said system being adapted to perform distance determination between the primary node and the at least two secondary nodes (SN) according to the method of the preceding claims.

14. A computer program product comprising instructions which, when the program is executed by a computer, cause the computer to carry out the steps of the method of claim 1.

## Patentansprüche

1. Verfahren zur Bestimmung einer physischen Entfernung zwischen Knoten (PN, SN) in einem kabelgebundenen Netzwerk (N), umfassend:
- Bereitstellen (S100) eines Primärknotens (PN) innerhalb des Netzwerks (N);
- Identifizieren (S200) von mindestens zwei verbundenen Sekundärknoten (SN) innerhalb des Netzwerks mittels des Primärknotens (PN), wobei jeder Sekundärknoten (SN) einen fernsteuerbaren Kondensator umfasst;
- Auffordern (S300) der mindestens zwei identifizierten Sekundärknoten (SN), ihren entsprechenden steuerbaren Kondensator unabhängig voneinander durch den Primärknoten (PN) zu aktivieren;
- wobei die Identifizierungs- und Aufforderungsschritte (S200, S300) mittels eines Kommunikationskanals zwischen den Knoten durchgeführt werden, der unabhängig vom kabelgebundenen Netzwerk ist;
- Erzeugen und Übertragen (S400) eines Messsignals innerhalb des Netzwerks durch den Primärknoten (PN) und anschließendes Messen, Verarbeiten und Aufzeichnen (S500) der Eigenschaften des reflektierten Signals; und
- Bestimmen (S600) der physischen Entfernung (d) zwischen dem Primärknoten (PN) und den mindestens zwei Sekundärknoten (SN) auf der Grundlage der aufgezeichneten reflektierten verarbeiteten Signaleigenschaften innerhalb des kabelgebundenen Netzwerks (N).

2. Verfahren nach Anspruch 1, wobei jeder Sekundärknoten eine Kennung (ID) umfasst, die während des Identifizierungsschritts an den Primärknoten (PN) übertragbar ist, wobei die Kennung einer eindeutigen logischen Identifizierung jedes Sekundärknotens (SN) im Netzwerk (N) entspricht.

3. Verfahren nach mindestens einem der Ansprüche 1 oder 2, wobei der Primärknoten (PN) mindestens einen Transceiver (TX) zum Senden und Empfangen von Signalen innerhalb des Netzwerks (N) umfasst.

4. Verfahren nach mindestens einem der vorstehenden Ansprüche, wobei das Messsignal einem linearen Signal-Sweep in einem Frequenzbereich zwischen zwei vorgegebenen Werten (fmin, fmax) entspricht.

5. Verfahren nach Anspruch 4, wobei das Aufzeichnen (S500) das Speichern einer Frequenzantwort in Bezug auf den Frequenzbereich des Sweep-Signals durch den Primärknoten (PN) umfasst.

6. Verfahren nach Anspruch 5, das ferner das Verarbeiten der gespeicherten Frequenzantwort umfasst, um eine spezifische Signalform zu bestimmen, wobei die spezifische Form mit einem spezifischen Frequenzwert innerhalb des Frequenzbereichs assoziiert ist.

7. Verfahren nach Anspruch 6, wobei die spezifische Signalform eine Signalauskerbung ist.

8. Verfahren nach einem oder mehreren der vorstehenden Ansprüche, wobei der fernsteuerbare Kondensator einen Kondensator umfasst, dessen Kapazitätswert fernsteuerbar eingestellt werden kann.

9. Verfahren nach einem oder mehreren der vorstehenden Ansprüche, wobei jeder Sekundärknoten (SN) ein fernsteuerbares reflektierendes Material oder ein reflektierendes Mittel im Allgemeinen umfasst.

10. Verfahren nach den Ansprüchen 6 und 7, das ferner das Speichern des spezifischen Frequenzwerts in Bezug auf jeden Sekundärknoten des kabelgebundenen Netzwerks in einem dem Primärknoten (PN) zugeordneten Speichermittel (30) umfasst.

11. Verfahren nach Anspruch 10, wobei die Bestimmung der physischen Entfernung (d) zwischen dem Primärknoten und den mindestens zwei Sekundärknoten auf der Grundlage der Frequenzwerte innerhalb der Speichereinrichtung (30) erfolgt.

12. Verfahren nach einem oder mehreren der vorstehenden Ansprüche, wobei das kabelgebundene Netzwerk (N) ein Stromnetz, ein optisches Netzwerk, ein Ethernet-Netzwerk oder ein proprietäres kabelgebundenes Netzwerk ist.

13. System, das einen Primärknoten (PN) und mindestens zwei Sekundärknoten (SN) umfasst, die in einem kabelgebundenen Netzwerk (N) miteinander verbunden sind, wobei das System dazu ausgelegt ist, die Entfernung zwischen dem Primärknoten und den mindestens zwei Sekundärknoten (SN) gemäß dem Verfahren der vorstehenden Ansprüche zu bestimmen.

14. Ein Computerprogrammprodukt, das Anweisungen umfasst, die, wenn das Programm von einem Computer ausgeführt wird, den Computer veranlassen, die Schritte des Verfahrens nach Anspruch 1 auszuführen.

## Revendications

1. Procédé pour déterminer une distance physique entre des nœuds (PN, SN) dans un réseau câblé (N), comprenant :
- la présence (S100) d'un nœud principal (PN) dans le réseau (N) ;
- l'identification (S200) d'au moins deux nœuds secondaires (SN) connectés par le nœud principal (PN) au sein du réseau, chaque nœud secondaire (SN) comprenant un condensateur contrôlable à distance ;
- la demande à (S300) au moins deux nœuds secondaires identifiés (SN) d'activer indépendamment leur condensateur contrôlable correspondant par le nœud primaire (PN) ;
- où les étapes d'identification et de demande (S200, S300) sont effectuées au moyen d'un canal de communication entre lesdits nœuds, qui est indépendant du réseau câblé ;
- la génération et la transmission (S400) d'un signal de mesure au sein du réseau par le nœud primaire (PN), puis mesurer, traiter et enregistrer (S500) les caractéristiques du signal réfléchi ; et
- la détermination (S600) de la distance physique (d) entre le nœud primaire (PN) et les au moins deux nœuds secondaires (SN) sur la base des caractéristiques du signal traité réfléchi enregistrées au sein du réseau câblé (N).

2. Procédé selon la revendication 1, dans lequel chaque nœud secondaire comprend un identifiant (ID) transmissible au nœud primaire (PN) pendant l'étape d'identification, l'identifiant correspondant à une identification logique unique de chaque nœud secondaire (SN) dans le réseau (N).

3. Procédé selon au moins l'une des revendications 1 ou 2, dans lequel le nœud primaire (PN) comprend au moins un émetteur-récepteur (TX) pour envoyer et recevoir des signaux au sein du réseau (N).

4. Procédé selon au moins l'une des revendications précédentes, dans lequel le signal de mesure correspond à un balayage linéaire de signaux dans une gamme de fréquences comprise entre deux valeurs prédéterminées (fmin, fmax).

5. Procédé selon la revendication 4, dans lequel l'enregistrement (S500) comprend le stockage d'une réponse en fréquence par rapport à ladite plage de fréquences dudit signal de balayage par le nœud primaire (PN).

6. Procédé selon la revendication 5, comprenant en outre le traitement de la réponse en fréquence stockée afin de déterminer une forme de signal spécifique, la forme spécifique étant associée à une valeur de fréquence spécifique dans la plage de fréquences.

7. Procédé selon la revendication 6, dans lequel la forme de signal spécifique est une encoche de signal.

8. Procédé selon au moins l'une des revendications précédentes, dans lequel ledit condensateur contrôlable à distance comprend un condensateur dont la valeur de capacité peut être réglée à distance.

9. Procédé selon au moins l'une des revendications précédentes, dans lequel chaque nœud secondaire (SN) comprend un matériau réfléchissant contrôlable à distance ou un moyen de réflexion en général.

10. Procédé selon les revendications 6 et 7, comprenant en outre le stockage de la valeur de fréquence spécifique relative à chaque nœud secondaire du réseau câblé dans un moyen de stockage (30) associé au nœud primaire (PN).

11. Procédé selon la revendication 10, dans lequel la détermination de la distance physique (d) entre le nœud primaire et les au moins deux nœuds secondaires est effectuée sur la base des valeurs de fréquence contenues dans ledit moyen de stockage (30).

12. Procédé selon au moins l'une des revendications précédentes, dans lequel le réseau câblé (N) est un réseau électrique, un réseau optique, un réseau Ethernet ou un réseau câblé propriétaire.

13. Système comprenant un nœud primaire (PN) et au moins deux nœuds secondaires (SN) interconnectés dans un réseau câblé (N), ledit système étant adapté pour effectuer la détermination de la distance entre le nœud primaire et les au moins deux nœuds secondaires (SN) selon le procédé des revendications précédentes.

14. Un produit logiciel comprenant des instructions qui, lorsque le programme est exécuté par un ordinateur, amènent l'ordinateur à exécuter les étapes du procédé selon la revendication 1.
